(19) Europäisches Patentamt
European Patent Office
Office européen des brevets

(11) Publication number: **0 119 017**
**B1**

(12) # EUROPEAN PATENT SPECIFICATION

(45) Date of publication of patent specification: **13.01.88**

(51) Int. Cl.⁴: **G 03 F 7/10,** C 08 F 220/28, C 08 F 220/40 // (C08F220/40, 220:28),(C08F220/28, 220:40)

(21) Application number: **84300919.2**

(22) Date of filing: **14.02.84**

(54) **Electron-beam and X-ray sensitive polymers and resists.**

(30) Priority: **15.02.83 US 466710**

(43) Date of publication of application:
**19.09.84 Bulletin 84/38**

(45) Publication of the grant of the patent:
**13.01.88 Bulletin 88/02**

(84) Designated Contracting States:
**DE FR GB**

(56) References cited:
**EP-A-0 043 116**
**US-A-3 639 348**

(73) Proprietor: **EASTMAN KODAK COMPANY**
**343 State Street**
**Rochester New York 14650 (US)**

(72) Inventor: **Tan, Zoilo Chen-Ho**
**171 Chimney Hill Road**
**Rochester New York 14612 (US)**
Inventor: **Daly, Robert Curtis**
**617 Meadowbriar Road**
**Rochester New York 14616 (US)**

(74) Representative: **Baron, Paul Alexander Clifford et al**
**Kodak Limited Patent Department**
**Headstone Drive**
**Harrow Middlesex HA1 4TY (GB)**

**EP 0 119 017 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to negative-working polymers suitable for exposure to electron beams or X-rays to form a resist image.

Electron-beam resists are at the forefront of the manufacture of integrated circuits because they permit the formation of smaller images than do resists which are responsive only to light radiation. It is desirable that such electron-beam resists have a minimum sensitivity of $5 \times 10^{-7}$ coulombs/$cm^2$ when exposed to a 15 keV electron beam, and have a resistance to deformation by the developer solvent and a resistance to subsequent fabrication steps, e.g., etching, ion implantation, etc.

A negative-working electron-beam resist is described in US—A—4,289,842. That resist comprises, in certain embodiments, copolymers of allyl methacrylate. Although such a resist has been particularly useful, it has demonstrated on occasion, and for reasons that are not completely understood, a sensitivity to the environment in which it is coated. More specifically, unless steps are taken to reduce such things as the amount of humidity in the environment, this resist tends occasionally to form severe "edge scaling" (i.e., residual amounts of unexposed polymer, resembling scales, projecting from the edges of the image after development and which are not removable). Although the problem can be overcome by controlling the environment, it would be advantageous to develop a negative-working resist of comparable quality that is not so sensitive to environmental conditions.

This problem is solved with a novel negative-working polymer that is at least as sensitive as $5 \times 10^{-7}$ coulombs per $cm^2$ when exposed to a 15 KeV electron-beam, said polymer comprising recurring A and B units having the structural formulae

A

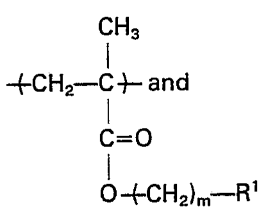

and

B

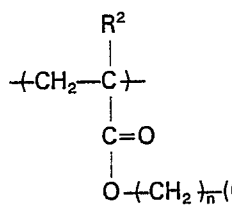

, respectively

wherein $R^1$ is $-CH=CH_2$ or $-C \equiv CH$,

$R^2$ is methyl or hydrogen,

Z is a heterocyclic ring having from 3 to 6 ring atoms selected from carbon and oxygen,

m = 0, 1, 2, or 3,

n = 1 or 2, and

r is 0 or 1,

said A unit being 50 to 95 mole percent of said polymer and said B unit being 5 to 50 mole percent of said polymer.

When coated in a layer on supports, the polymers of the invention are useful as electron-beam resists. The polymers of the invention are also useful as resists for exposure to other forms of high energy radiation, such as x-ray radiation.

Certain polymers of the invention demonstrate both outstanding E-beam sensitivity and resistance to edge scaling under a variety of environmental conditions. As used herein, "edge scaling" refers to scales formed on resist images. For example, under certain high humidity conditions, resist poly(allyl methacrylate-co-hydroxyethyl methacrylate), having a $\overline{Mw}$ of 42,000, following exposure to a line pattern spaced 5 to 10 µm apart and development with the solvent 2-ethoxyethyl acetate/isopropyl alcohol (1:1 by volume), will show under a microscope, resist portions that look like scales projecting away from the edges of lines. The scale portions are unexposed portions of the resist polymer which not only were not developed (removed) by the solvent, but also are resistant to removal by conventional descumming procedures. Such scales are distinguishable from minor scum sometimes encountered, which is readily removable by an oxygen plasma. The scales are, of course, objectionable because they act as a protective resist over areas of the substrate that should not be protected from subsequent etching.

The resist comprises the copolymers described above. As noted, Z is a heterocyclic ring, and as used herein, "heterocyclic ring" includes both substituted and unsubstituted heterocyclic rings, as well as saturated and unsaturated heterocyclic rings having the ring atoms that conform to the specified requirements. Preferred examples of substituents on such substituted rings include one or two alkyl groups each of from 1 to 3 carbon atoms, that is to say methyl, ethyl, propyl or isopropyl; halo, for example, chloro, fluoro, and the like; cyano; and alkoxy of from 1 to 3 carbon atoms, for example, methoxy, ethoxy, and propoxy. Particularly preferred heterocyclic rings include glycidyl; furyl; pyranyl; and 2,2-dimethyldioxalanyl. Particularly preferred examples of useful copolymers for this invention include poly(allyl methacrylate-co-glycidyl methacrylate); poly(allyl methacrylate-co-2,2-dimethyl-4-dioxalanylmethyl methacrylate); poly(propargyl methacrylate-co-2,2-dimethyl-4-dioxalanylmethyl methacrylate); poly[allyl methacrylate-co(2H-2-tetrahydropyranyloxy)ethyl methacrylate]; poly(allyl

methacrylate-co-2-furfuryl methacrylate); poly(propargyl methacrylate-co-glycidyl methacrylate); and poly(allyl methacrylate-co-2,2-dimethyl-4-dioxalanylmethyl acrylate).

Other comonomers can be included to form recurring units in the polymer of the invention, provided that they are compatible with the preferred comonomers (i.e., they do not interfere with the crosslinking of the polymer). Preferably, to insure maximum sensitivity and etch resistance, the A and B units together comprise at least 70 mole percent of the polymer. Other comonomers are preferably not included. It has been found that the polymers of the invention have better adhesion with high speed and good plasma etch resistance.

The polymers of the invention have electron-beam sensitivities of at least $5 \times 10^{-7}$ coulombs/$cm^2$. Such results are achieved for weight average molecular weights (herein "$\overline{Mw}$") that are, in most cases, below 100,000. Thus, the polymers of the invention can be used to prepare very sensitive negative-working electron-beam recording resists. Electron-beam sensitivities herein described were determined, as is conventional, by exposing identical coatings to increased dosage values and measuring the amount of resist remaining in the exposed area after development. The sensitivity is that dosage required to crosslink enough of the composition to retain 50 percent of the initial coating thickness. The smaller the dosage, the less energy that is required, and therefore the more sensitive is the polymer.

The molecular weights of useful polymers of the invention vary widely. Preferably the polymer has a low enough viscosity in the solvent of choice to permit it to be coated. It has been found that useful viscosities are generally 0.3 inherent viscosity or less, as measured in N,N-dimethylformamide at 25°C. However, very low-molecular weights tend to reduce electron-beam sensitivity. Preferably, therefore, the styrene equivalent weight average molecular weight of the polymer, as determined by gel permeation chromatography analysis, is between 10,000 and 70,000. Most preferably, it is between 25,000 and 45,000 for the dioxalanyl copolymers, 30,000 to 50,000 for the glycidyl and furfuryl copolymers, and 25,000-55,000 for the tetrahydropyranyloxy copolymers.

A further advantage of the polymers of the invention is in improved film properties of the coated polymers, such as adhesion to supports that are to be resist-coated. These properties are unexpectedly superior compared to the properties of the homopolymers that result when one of the comonomers is not present. For example, the homopolymer of allyl methacrylate demonstrates unsatisfactory adhesion to chrome-clad glass when exposed to dosages greater than $5 \times 10^{-7}$ coulomb/$cm^2$. Similarly, the homopolymer of propargyl methacrylate tends to lose adhesion when over-exposed. Poly(dioxalanyl methacrylate) also fails to adhere following image development, for the reason that it is insensitive to E-beams at the aforesaid dosage and will not cross-link to provide insoluble portions. Poly(glycidyl methacrylate), though adherent, is unstable when stored.

The polymers of the invention can be prepared by conventional synthesis techniques. Dilute reaction conditions are preferred to avoid undesirable crosslinking. Examples 1 to 4 below illustrate the preparation of polymers of the invention.

Example 1

Poly(allyl methacrylate-co-2,2-dimethyl-4-dioxalanylmethyl methacrylate)

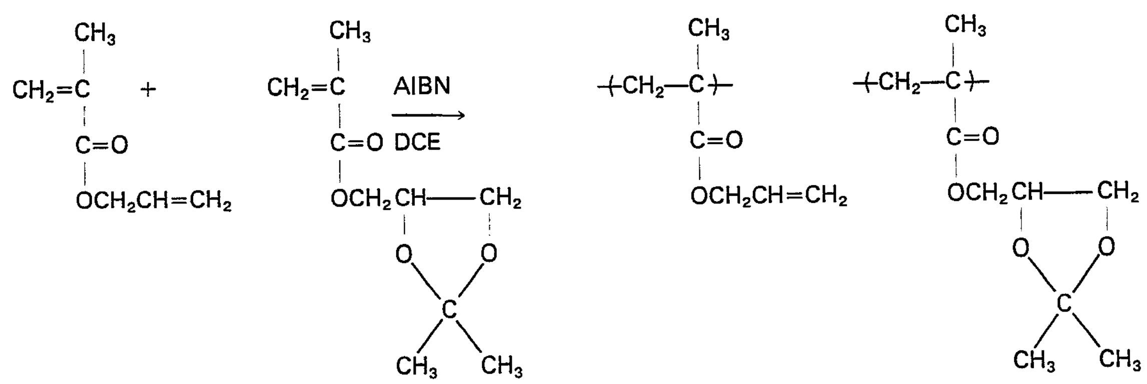


In a 5l 3-neck flask, 2.5l of 1,2-dichloroethane (DCE) was heated under a nitrogen atmosphere to a mild reflux. A monomer solution was prepared containing:

100 g allyl methacrylate (0.79 mole)

56.6 g 2,2-dimethyl-4-dioxalanylmethyl methacrylate (0.26 mole)

0.87 g 2,2'-azobis(2-methylpropionitrile) (AIBN) 750 ml DCE.

The monomer solution was added slowly to the stirred, refluxing DCE (over a one-hour period). Reflux was maintained for 20 hours after the addition was completed. The reaction mixture was allowed to cool, filtered, and reduced to ≈1l on the rotary evaporator. The product was precipitated into 10l of vigorously stirred heptane. The precipitate was collected on a Buchner funnel, washed with fresh helptane, then dried under vacuum with a nitrogen bleed at 20°C. for 48 hours. Yield: 102.4 g (65%). (In the allyl methacrylate polymer products herein described, there is present some amount of polymerized cyclized allyl methacrylate monomer that does not conform to the structure noted.)

Elemental Analysis

| | | N% | C% | H% |
|---|---|---|---|---|
| GPC $\overline{Mn}$ = 18,469 | Theory | 0 | 64.3 | 8.0 |
| $\overline{Mw}$ = 42.641 | Found | <0.3 | 64.2 | 8.0 |

Ratio ($\overline{Mn}/\overline{Mw}$) = 2.31

Example 2
Poly(allyl methacrylate-co-glycidyl methacrylate)

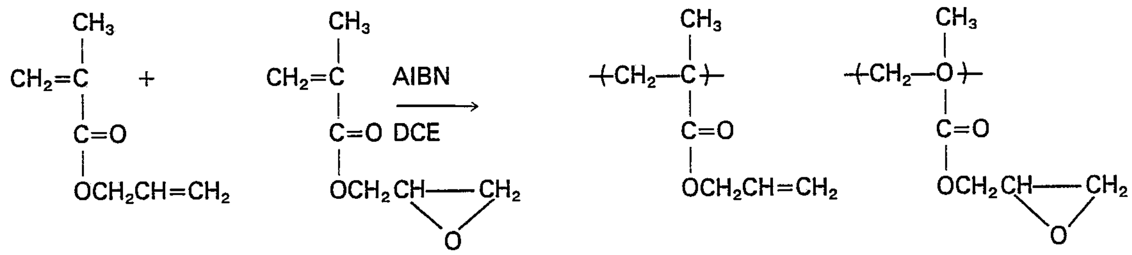


A 12-liter round-bottom reaction vessel equipped with magnetic stirrer, reflux condenser, pressure-equalized dropping funnel, nitrogen inlet and heating mantle was charged with 4.5 liters of DCE. The system was purged with nitrogen and reflux established. To the reaction vessel was added dropwise a solution of 200 g of allyl methacrylate (1.59 moles), 75 g of glycidyl methacrylate (0.53 mole), and 3 g of 2,2'-azobis(2-methylpropionitrile) (AIBN) ($1.8 \times 10^{-2}$ moles) in 1 liter of DCE, over the period of 1/2 hour. Reflux was maintained for 15 hours. One-half of the solvent was removed on a rotary evaporator and the remaining solution was added dropwise to 25 liters of vigorously stirred heptane to precipitate the polymer. The white, solid polymer was collected on a filter funnel, washed twice with 500 ml of fresh heptane, and dried in vacuum with no heat. 210 g yield, 76%. $\overline{Mw}$ = 34,459, $\overline{Mn}$ = 14,407, $\overline{Mw}/\overline{Mn}$ = 2.39 by gel permeation chromatography.

Example 3
Preparation of Poly[allyl methacrylate-co-2-(tetrahydropyran-2-yloxy)ethyl methacrylate)]

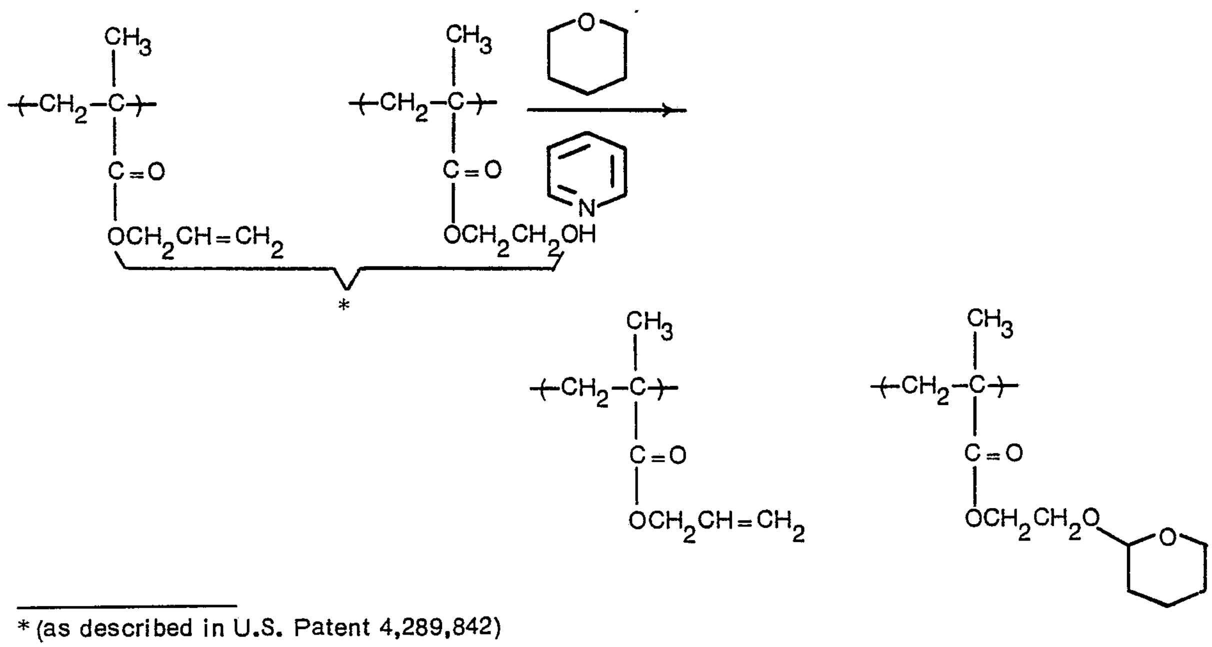


* (as described in U.S. Patent 4,289,842)

The starting copolymer was dissolved in 1800 ml of dry pyridine. The solution was stirred under nitrogen and warmed to reflux. Dihydropyran (25.5 g, 0.30 mole) was then added and the reflux continued for 6 hours. The reaction mixture was then cooled to room temperature and filtered to remove any insoluble polymer.

The polymer solution was precipitated into water through an aspirator and washed completely with cold water several times. The polymer was collected and dried at 20°C. under vacuum with a nitrogen bleed for 72 hours. Yield: 94 g.

Example 4

Preparation of Poly(propargyl methacrylate-co-glycidyl methacrylate

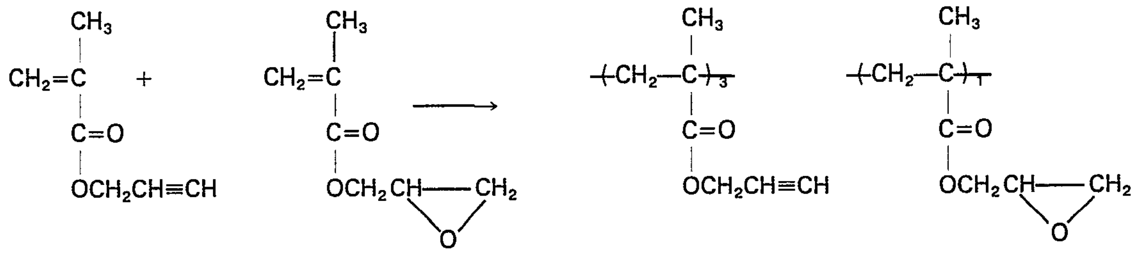

DCE (2.7l) was warmed to gentle reflux with stirring under a nitrogen atmosphere. A monomer-initiator solution was prepared by dissolving 111.7 g (0.9 mole) of propargyl methacrylate, 42.7 g (0.3 mole) of glycidyl methacrylate and 0.77 g of A1BN in 700 ml of DCE. Reflux was continued while the monomer-initiator solution was added over a 30-minute period. Reflux continued for 16 hours and then the reaction vessel was allowed to return to 20°C.

The polymer solution was reduced in volume to about 1.5l, on a rotary evaporator. The reduced solution was added dropwise to 12l of vigorously stirred heptane. A granular white precipitate was obtained and isolated by collecting on a filter. The collected polymer was washed twice with heptane and dried at 20°C. under vacuum with a nitrogen bleed.

Obtained — 50 g of white polymer (32%)

$\overline{Mn}$ = 6867, $\overline{Mw}$ = 9609, $\overline{Mw}/\overline{Mn}$ = 1.4 (polystyrene equivalent weights)

Elemental Analysis

| | %C | %H | %O |
|---|---|---|---|
| Theory | 65.4 | 6.7 | 28.0 |
| Found | 65.3 | 6.7 | 26.7 |

As a resist, the polymers of the invention are preferably coated onto the support that is to be etched. Preferably the coating composition is free of sensitizers and initiators, to permit white-light handling. The resist is then dried, imagewise exposed, and developed to remove the unexposed portions. Any suitable support is useful. Particularly preferred examples of supports include semiconductors such as silicon wafers, chrome-clad glass, and metals such as aluminum.

Conventional solvents are useful for both the coating step and the development step. Preferred examples of solvents useful for either process step include 2-methoxyethyl acetate, 2-ethoxyethyl acetate, 2-ethoxyethanol, 2-butanone, cyclohexanone, cyclopentanone, 4 butyrolactone, and mixtures of these with 2-propanol or ethanol.

Conventional coating procedures are useful to apply the polymer to the support. Preferred are whirler or spin coating, brushing, doctor-blade coating, or hopper coating. Further details of such conventional procedures are described in *Product Licensing Index,* Vol. 92, Dec. 1971, Publication No. 9232, at p. 109.

The drying step is preferably accomplished by baking in an oven, optionally in a vacuum, for example, at 90°C. for 30 minutes.

Optionally, a conventional post-bake step is included after exposure and development to enhance adhesion of the final resist coating to the areas to be protected, prior to etching.

Etching of the underlying support is achieved by using a chemical solvent for the support, or by treatment with a plasma gas, both of which are conventional.

Examples 5 to 13 below illustrate the use of polymers of invention as resists.

To demonstrate resistance to edge scaling, the polymers of Table I in 2-ethoxyethyl acetate were coated onto $SiO_2$-coated silicon wafers at a thickness of 0.5 micron (each example). The resist polymers were imagewise exposed to an electron beam of 20 keV energy, stored at 100 percent relative humidity for about 12 hours, and developed in 1:1 (by volume) 2-ethoxyethyl acetate/isopropanol for 30 seconds. Thereafter, the samples were spin-spray rinsed with isopropanol. The resistance to edge scaling was determined by microscopic observation-see Table I.

TABLE I

| Example | Polymer | Was Edge Scaling Present? |
|---|---|---|
| Control | Poly(allyl methacrylate-co-hydroxyethyl methacrylate) (3:1)* | Yes |
| 5 | Poly(allyl methacrylate-co-glycidyl methacrylate) (3:1) | No — free of edge scaling |
| 6 | Poly(allyl methacrylate-co-2,2-dimethyl-4-dioxalanylmethyl methacrylate) (3:1) | No — free of edge scaling |
| 7 | Poly(propargyl methacrylate-co-2,2-dimethyl-4-dioxalanylmethyl methacrylate) (3:1) | No — free of edge scaling |
| 8 | Poly[allyl methacrylate-co-2-(2H-2-tetrahydropyranyloxy)ethyl methacrylate] (3:1) | No — free of edge scaling |
| 9 | Poly(allyl methacrylate-co-furfuryl methacrylate) (3:1) | No — free of edge scaling |

* All ratios of this table are expressed in terms of the mole ratios of the comonomers incorporated into the polymer.

Examples 5 to 9 were repeated, and these coated wafers were exposed at 15 keV to determine their sensitivity. Sensitivity curves were plotted, and the contrast was determined as the slope of the sensitivity curve at the 50 percent thickness point. A Comparative Example was prepared by the procedure of Example 5, except that the polymer was poly(allyl methacrylate-co-4-methyl-2H-2-pyranon-6-ylmethyl methacrylate at a $\overline{Mw}$ of 30,700. (See British Patent Pub. 1,446,981.) The results appear in Table II.

TABLE II

| Example | Polymer | Mw | Sensitivity (Coulombs/cm$^2$) | Contrast |
|---|---|---|---|---|
| 5 | Poly(allyl methacrylate-co-glycidyl methacrylate) | 34,500 | $3.4 \times 10^{-7}$ | 1.1 |
| 6 | Poly(allyl methacrylate-co-2,2-dimethyl-4-dioxalanyl methyl methacrylate) | 38,400 | $3.5 \times 10^{-7}$ | 1.2 |
| 7 | Poly(propargyl methacrylate-co-2,2-dimethyl-4-dioxalanyl methyl methacrylate) | 10,400 | $2.2 \times 10^{-7}$ | 1.0 |
| 8 | Poly[allyl methacrylate-co-2-(2H-2-tetrahydropyranyloxy)ethyl methacrylate] | 42,000 | $2 \times 10^{-7}$ | 0.94 |
| 9 | Poly(allyl methacrylate-co-2-furfuryl methacrylate) | 62,400 | $5.0 \times 10^{-7}$ | 0.85 |
| Comparative Example | | N.A. (not available) | $6.0 \times 10^{-7}$ | 1.1 |

The value of $6.0 \times 10^{-7}$ of the comparative example, by reason of the larger exposure required as indicated by the larger number, is not as sensitive as the values $\leq 5 \times 10^{-7}$ provided by the polymers of the invention, and was considered unacceptable.

Examples 10-12

Examples 5, 6 and 8 were repeated as Examples 10—12, and following development, the samples were etched with a plasma etch of 91.5% $CF_4$ and 8.5% $0_2$, applied at 100 w, 0.7 Torr pressure. As controls, two separate layers of poly(methyl methacrylate) and a commercial copolymer of glycidylmethacrylate and ethyl acrylate, available under the trademark "KTI/MEAD COP" from KTI Chemicals, Inc., were similarly coated, exposed, developed and etched. Examples 10—12 demonstrated greater etch resistance than did the two controls.

Example 13

Poly(allyl methacrylate-co-2,2-dimethyl-4-dioxalanylmethyl acrylate), having a mole ratio of 3:1 for the comonomers incorporated into the polymer, was coated onto a chrome-clad glass, exposed to a 15 KeV electron beam, and developed for 1 minute with a 1:1 mixture of 2-ethoxyethyl acetate and ethanol. The sensitivity and contrast were found to be $4.1 \times 10^{-7}$ coulombs/$cm^2$ and 1.22, respectively.

## Claims

1. A negative-working polymer that is at least as sensitive as $5 \times 10^{-7}$ coulombs per $cm^2$ when exposed to a 15 KeV electron-beam, said polymer comprising recurring A and B units having the structural formulae

A

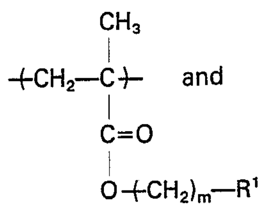

and

B

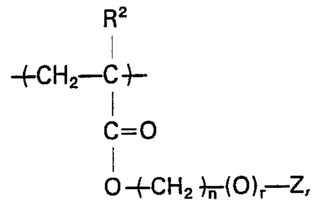

, respectively

wherein $R^1$ is $—CH{=}CH_2$ or $—CH{\equiv}CH$,

$R^2$ is methyl or hydrogen,

Z is a heterocyclic ring having from 3 to 6 ring atoms selected from carbon and oxygen,

m is 0, 1, 2, or 3,

n is 1 or 2, and

r is 0 or 1,

said A unit being 50 to 95 mole percent of said polymer and said B unit being 5 to 50 mole percent of said polymer.

2. A polymer according to Claim 1 wherein said A and B units form a poly(allyl methacrylate-co-glycidyl methacrylate).

3. A polymer according to Claim 1 wherein said A and B units form a poly(allyl methacrylate-co-2,2-dimethyl-4-dioxalanylmethyl methacrylate).

4. A polymer according to Claim 1 wherein said A and B units form a poly(propargyl methacrylate-co-2,2-dimethyl-4-dioxalanylmethyl methacrylate).

5. A polymer according to Claim 1 wherein said A and B units form a poly[allyl methacrylate-co-(2H-2-tetrahydropyranyloxy)ethyl methacrylate].

6. A polymer according to Claim 1 wherein said A and B units form a poly(allyl methacrylate-co-2-furfuryl methacrylate).

7. A polymer according to Claim 1 wherein said A and B units form a poly(propargyl methacrylate-co-glycidyl methacrylate).

8. A polymer according to Claim 1 wherein said A and B units form a poly(allyl methacrylate-co-2,2-dimethyl-4-dioxalanylmethyl acrylate).

9. A polymer as in Claim 1 having a weight average molecular weight below 100,000.

10. A polymer as in Claim 1 wherein the A and B units constitute at least 70 percent of said polymer.

11. An E-beam or x-ray sensitive element comprising a support having thereon a layer of a polymer as defined in any of Claims 1 to 8.

**Patentansprüche**

1. Negativ arbeitendes Polymer, das mindestens so empfindlich ist wie $5 \times 10^{-7}$ Coulomb/$cm^2$, wenn

es einem Elektronenstrahl von 15 KeV exponiert wird und das wiederkehrende Einheiten A und B der folgenden Strukturformeln aufweist:

A

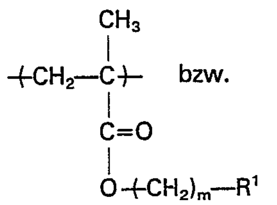

bzw.

B

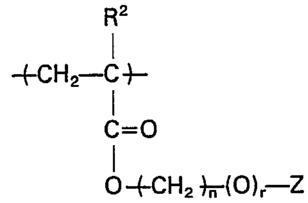

worin bedeuten:

$R^1$ einen Rest der Formeln: $-CH=CH_2$ oder $-C\equiv CH-$,

$R^2$ einen Methylrest oder ein Wasserstoffatom,

Z einen heterocyclischen Ring mit 3 bis 6 Ringatomen, ausgewählt aus Kohlenstoff- und Sauerstoffatomen,

m gleich 0, 1, 2 oder 3,

n gleich 1 oder 2 und

r gleich 0 oder 1,

wobei die Einheit A 50 bis 95 Mol-% des Polymeren und die Einheit B 5 bis 50 Mol-% des Polymeren ausmachen.

2. Polymer nach Anspruch 1, in dem die Einheiten A und B ein Poly(allylmethacrylat-co-glycidylmethacrylat) bilden.

3. Polymer nach Anspruch 1, in dem die Einheiten A und B ein Poly(allylmethacrylat-co-2,2-dimethyl-4-dioxalanylmethylmethacrylat) bilden.

4. Polymer nach Anspruch 1, in dem die Einheiten A und B ein Poly(propargylmethacrylat-co-2,2-dimethyl-4-dioxalanylmethylmethacrylat) bilden.

5. Polymer nach Anspruch 1, in dem die Einheiten A und B ein Poly[allylmethacrylat-co-(2H-2-tetrahydropyranyloxy)-ethylmethacrylat] bilden.

6. Polymer nach Anspruch 1, in dem die Einheiten A und B ein Poly(allylmethacrylat-co-2-furfurylmethacrylat) bilden.

7. Polymer nach Anspruch 1, in dem die Einheiten A und B ein Poly(propargylmethacrylat-co-glycidylmethacrylat) bilden.

8. Polymer nach Anspruch 1, in dem die Einheiten A und B ein Poly(allylmethacrylat-co-2,2-dimethyl-4-dioxalanylmethylacrylat) bilden.

9. Polymer nach Anspruch 1 mit einem durchschnittlichen Molekulargewicht von unter 100 000.

10. Polymer nach Anspruch 1, in dem die Einheiten A und B mindestens 70% des Polymeren ausmachen.

11. Elektronenstrahl- oder Röntgenstrahl-empfindliches Element mit einem Träger und einer hierauf aufgetragenen Schicht aus einem Polymeren nach einem der Ansprüche 1 bis 8.

**Revendications**

1. Polymère à effet négatif ayant une sensibilité d'au moins $5 \times 10^{-7}$ coulombs par $cm^2$ quand on l'expose à un faisceau d'électrons de 15 KeV, ce polymère comprenant des motifs A et B ayant la structure:

A

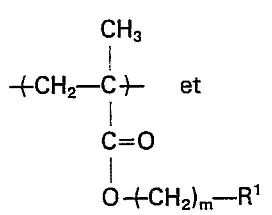

et

B

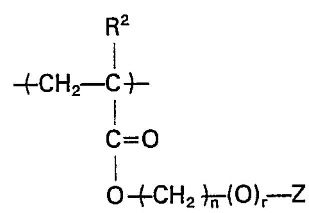

respectivement,

où

R' est $-CH=CH_2$ ou $-C\equiv CH$,

$R^2$ est un groupe méthyle ou un atome d'hydrogène,

Z est un noyau hétérocyclique ayant de 3 à 6 atomes dans le noyau, choisis parmi le carbone et l'oxygène,

m est égal à 0, 1, 2 ou 3,

n est égal à 1 ou 2,

r est égal à 0 ou 1,

le motif A représentant de 50 à 95% en mole du polymère, et le motif B représentant de 5 à 50% en mole du polymère.

2. Polymère conforme à la revendication 1, dans lequel les motifs A et B forment un copolymère de méthacrylate d'allyle et de méthacrylate de glycidyle.

3. Polymère conforme à la revendication 1, dans lequel les motifs A et B forment un copolymère de méthacrylate d'allyle et de méthacrylate de 2,2-diméthyl-4-dioxalanylméthyle.

4. Polymère conforme à la revendication 1, dans lequel les motifs A et B forment un copolymère de méthacrylate propargyle et de méthacrylate de 2,2-diméthyl-4-dioxalanylméthyle.

5. Polymère conforme à la revendication 1, dans lequel les motifs A et B forment un copolymère de méthacrylate d'allyle et de méthacrylate de (2H-2-tétrahydropyranyloxy)éthyle.

6. Polymère conforme à la revendication 1, dans lequel les motifs A et B forment un copolymère de méthacrylate d'allyle et de méthacrylate de 2-furfuryle.

7. Polymère conforme à la revendication 1, dans lequel les motifs A et B forment un copolymère de méthacrylate de propargyle et de méthacrylate de glycidyle.

8. Polymère conforme à la revendication 1, dans lequel les motifs A et B forment un copolymère de méthacrylate d'allyle et d'acrylate de 2,2-diméthyl-4-dioxalanylméthyle.

9. Polymère conforme à la revendication 1, ayant un poids moléculaire moyen en masse inférieur à 100 000.

10. Polymère conforme à la revendication 1, dans lequel les motifs A et B représentant au moins 70% du polymère.

11. Produit sensible aux faisceaux d'électrons ou aux rayons X comprenant un support et, sur ce support, une couche du polymère tel que défini dans l'une quelconque des revendications 1 à 8.